# EUROPÄISCHE PATENTANMELDUNG

(11) **EP 4 707 425 A1**
(43) Veröffentlichungstag der Anmeldung: **11.03.2026**
(21) Anmeldenummer: 25195275.0
(22) Anmeldetag: 12.08.2025
(51) Int. Cl.: C23C 14/50, C23C 16/458

(54) **SUBSTRATTRÄGER**

(30) Priorität: 27.08.2024 DE 102024124454
(71) Anmelder: Esser, Stefan, 52072 Aachen (DE)
(72) Erfinder: Esser, Stefan, 52072 Aachen (DE)
(74) Vertreter: Bauer PSU PartG mbB

(57) **Zusammenfassung**

Offenbart ist ein Substratträger (4) mit einer vertikal verlaufenden Trägerachse (8) und einem rohrförmig um die Trägerachse (8) angeordneten Mantel (9), Substrathalterungen (12) zum Haltern jeweils eines Substrats (13), die um jeweils eine aus dem Mantel (9) weisende Substratachse (14) rotierbar in dem Mantel (9) gelagert sind, einem Antriebselement (15), das um die Trägerachse (8) relativ zu den Substrathalterungen (12) rotierbar ist. Offenbart ist weiterhin ein Antriebsverfahren für eine solche Substrathalterung (12).

Um die Anzahl rotierender Bauteile zu reduzieren wird erfindungsgemäß vorgeschlagen, Exzenter (19) vorzusehen, die das Antriebselement (15) um eine jeweils radial zu der Trägerachse (8) verlaufende Exzenterachse (24) rotierend antreibt und mindestens einen Mitnehmer (30), den die Exzenter (19) um die Trägerachse (8) taumelnd antreiben, und der die Substrathalterungen (12) synchron zu den Exzentern (19) um die jeweilige Substratachse (14) rotierend antreibt.

## Beschreibung

Die Erfindung betrifft einen Substratträger mit einer vertikal verlaufenden Trägerachse und einem rohrförmig um die Trägerachse angeordneten Mantel, Substrathalterungen zum Haltern jeweils eines Substrats, die um jeweils eine aus dem Mantel weisende Substratachse rotierbar in dem Mantel gelagert sind, einem Antriebselement, das um die Trägerachse relativ zu den Substrathalterungen rotierbar ist. Die Erfindung betrifft weiter ein Antriebsverfahren für eine Substrathalterung zum Haltern eines Substrats um eine aus einem Mantel weisende Substratachse, der um eine vertikal verlaufende Trägerachse eines Substratträgers angeordnet ist, mittels eines um die Trägerachse relativ zu der Substrathalterung rotierenden Antriebselements.

Auf solchen Substrathalterungen wird gleichzeitig eine Vielzahl von Substraten - beispielsweise kleine Massenbauteile für die Motortechnik - unter Reinstraumbedingungen und Vakuum und bei zugleich hohen Temperaturen in einer Beschichtungskammer in einem Gasabscheidungsverfahren beschichtet.

EP4265819A1 schlägt vor, an einem solchen Substratträger mehrere parallel zu der Trägerachse verlaufende Gruppen aus vertikal übereinander angeordneten Substrathalterungen zu bilden und die Substrathalterungen einer jeden Gruppe über jeweils eine kinematische Kette von übereinander angeordneten und ineinandergreifenden Zahnrädern anzutreiben. Die hohe Zahl rotierender und ineinandergreifender Bauteile führt unter den Betriebsbedingungen der Beschichtungskammer zu einem hohen Blockade- und Ausfallrisiko des bekannten Substratträgers.

Im Hintergrund der Erfindung schlägt DE102010001218A1 vor, zur Beschichtung in einem Gasabscheidungsverfahren die Rotation von vertikal auf einem Tisch stehenden Substraten über ein von einem Exzenter angetrieben taumelndes Zahnrad anzutreiben.

DE102019110158A1 offenbart einen Substratträger mit einem einzelnen, um die Trägerachse rotierenden Exzenter. Weitere Substratträger sind aus DE102019110158 A1, EP1025277B1, EP1153155B1, US20090056630A1, US4284033A, CN110241395A und CN219886170U bekannt.

### Aufgabe

Der Erfindung liegt die Aufgabe zugrunde, die Anzahl rotierender Bauteile zu reduzieren.

### Lösung

Ausgehend von dem bekannten Substratträger wird nach der Erfindung vorgeschlagen, Exzenter vorzusehen, die das Antriebselement um eine jeweils radial zu der Trägerachse verlaufende Exzenterachse rotierend antreibt und mindestens einen Mitnehmer, den die Exzenter um die Trägerachse taumelnd antreiben, und der die Substrathalterungen synchron zu den Exzentern um die jeweilige Substratachse rotierend antreibt. Der mindestens eine Mitnehmer ersetzt gegenüber dem bekannten Substratträger je Substrathalterung ein Zahnrad der kinematischen Kette und halbiert so die Anzahl der bewegten Teile.

Insbesondere um den CO₂-Ausstoß moderner Motoren zu verringern werden Bauteile mit reibungsarmen Verschleißschutzschichten beschichtet. Beschichten ist nach DIN 8580 ein Fertigungsverfahren zum Aufbringen einer festhaftenden Schicht aus formlosem Stoff auf die Oberfläche eines Werkstückes. Ein zu beschichtendes Werkstück wird in der Beschichtungstechnik als "Substrat" benannt. Viele Substrate (insbesondere Motorenbauteile wie Düsennadeln oder Steuerkolben) sind sehr klein, stellen aber zugleich hohe Anforderungen an die Gleichmäßigkeit der Beschichtung: Oft wird verlangt, dass weniger als 0,3 ppm der Teile einen "Drehfehler" aufweisen. Auf dem Substratträger werden zumeist mehrere 100 Substrate auf angepasste Substrathalterungen vereinzelt.

Durch die Taumelbewegung und die Unwuchten der Kurbeln entsteht an jedem Mitnehmer ein ungleichmäßiges Antriebsmoment. Die Unwuchten mehrerer unterschiedlich und/oder gegenläufig angetriebener und taumelnder Mitnehmer können sich derart ausgleichen, dass das Antriebsmoment eines erfindungsgemäßen Substratträgers vergleichmäßigt wird.

In einem erfindungsgemäßen Substratträger sind vorzugsweise die Exzenter in dem Mantel rotierbar gelagert. Die Halterung der Exzenter erfordert kann keine zusätzlichen Bauteile.

In einem erfindungsgemäßen Substratträger wandeln vorzugsweise jeweils miteinander kämmende Kegelräder an dem Antriebselement und den Exzentern eine Rotation des Antriebselements in eine Rotation um eine jeweils zu der Trägerachse radiale Exzenterachse der Exzenter. Kegelradgetriebe sind dem Fachmann allgemein bekannt. Alternativ kann eine Kurvenscheibe an dem Antriebselement den Mitnehmer antrieben. Der geringe Wirkungsgrad des Kegelradgetriebes unter der wegen der Reinraumbedingungen nur geringen Schmierung wird so vermieden.

In einem erfindungsgemäßen Substratträger ist vorzugsweise der mindestens eine Mitnehmer in einem Hohlraum des Mantels angeordnet. Ein solcher Substratträger weist vorzugsweise eine segmentierte Außenhülle auf, die die Wartung und den Austausch beschädigter Substrathalterungen erleichtert.

In einem solchen Substratträger ist vorzugsweise der Hohlraum abgesehen von Lagerstellen der Exzenter und der Substrathalterungen geschlossen. In dem Hohlraum und insbesondere wenn dieser geschlossen ist sind der mindestens eine Mitnehmer und die Kontaktstellen des mindestens einen Mitnehmers mit den Exzentern und mit den Substrathalterungen vor unbeabsichtigter Beschichtung geschützt.

In einem erfindungsgemäßen Substratträger weist vorzugsweise der mindestens eine Mitnehmer Bohrungen auf, in die die Exzenter und die Substrathalterungen eingreifen. Bohrungen sind eine einfache Möglichkeit, rotierende Elemente zu lagern. Alternativ können die Exzenter und/oder die Substrathalterungen in Gleit- oder Kugellager eingreifen.

In einem erfindungsgemäßen Substratträger ist vorzugsweise der mindestens eine Mitnehmer eine kreiszylindrische Trommel. Der mindestens eine Mitnehmer weist dann eine hohe Steifigkeit auf, die einen gleichmäßigen Antrieb aller Substrathalterungen gewährleistet. Alternativ kann der mindestens eine Mitnehmer eine Gitterstruktur aufweisen, in die die Exzenter und die Substrathalterungen eingreifen

In einem erfindungsgemäßen Substratträger tragen vorzugsweise die Exzenter den mindestens einen Mitnehmer. Der mindestens eine Mitnehmer benötigt dann keine weitere tragende Struktur.

In einem erfindungsgemäßen Substratträger verlaufen vorzugsweise die Substratachsen im Wesentlichen radial zu der Trägerachse. Die Taumelbewegung des mindestens einen Mitnehmers kann dann unmittelbar in die Rotation der Substratachsen umgewandelt werden. Die Substratachsen können um bis zu 20 ° aus der radialen Richtung zur Trägerachse geneigt sein. Die Beschichtung von Substraten mit gegen zur Substratachse geneigten Flächen wird durch die Neigung verbessert.

Vorzugsweise weist ein erfindungsgemäßer Substratträger eine Blockadesicherung auf. Beispielsweise können in einem erfindungsgemäßen Substratträger die Substratachsen eine Blockadesicherung aufweisen. Alternativ oder zusätzlich kann ein erfindungsgemäßer Substratträger eine Blockadesicherung an der Trägerachse oder an dem Antriebselement aufweisen. In einer erfindungsgemäßen Beschichtungskammer wird ein solcher erfindungsgemäßer Substratträger bei Blockade stillgelegt. Dem Fachmann sind insbesondere Sollbruchstellen zur Vermeidung einer Blockade bekannt.

Eine Beschichtungskammer mit mindestens einem Tisch parallel über einem Boden der Beschichtungskammer weist vorzugsweise mindestens einen erfindungsgemäßen Substratträger auf dem mindestens einen Tisch und einen Antrieb auf, mittels dessen der mindestens eine Tisch um eine vertikal verlaufende Tischachse und der mindestens eine Substratträger um die Trägerachse rotierbar ist. Eine solche Beschichtungskammer zeichnet sich durch die Vorteile der erfindungsgemäßen Substratträger aus. Allgemein bekannte Beschichtungskammern weisen einen Durchmesser von 30 bis 150 cm auf und fassen typischer Weise sechs bis 18 Substratträger auf einem Boden zusammen.

Die Substratträger werden von einem gemeinsamen zentralen Antrieb des Bodens angetrieben.

Eine solche Beschichtungskammer weist vorzugsweise einen Gasphasenabscheider auf. Zum Beschichten kleiner, hochpräziser Substrate kommen insbesondere die physikalische Gasphasenabscheidungs ("physical vapor deposition"/"PVD") und die plasmaunterstützte chemische Gasphasenabscheidung ("plasma enhanced chemical vapor deposition"/"PECVD") zum Einsatz. Im PVD-Verfahren ist das "Target" die Platte, die mit geladenen Teilchen beschossen wird. Dadurch wird Targetmaterial verdampft und im Vakuum, typischerweise zwischen 10 mPa und 3000 mPa als Schicht auf den relativ kalten Substraten abgeschieden. Häufig wird die Verdampfung durch eine elektrische Entladung herbeigeführt. Hier unterscheidet man die Elektronenstrahlverdampfung (EBPVD electron beam) die Lichtbogenverdampfung (AIP arc ion plating) und die Sputterverfahren (MSIP magnetron sputter ion plating).

Häufig wird auch die Abscheidung durch eine an die Substrate angelegte Spannung beeinflusst. Diese Spannung wird Biasspannung genannt und sie beeinflusst die Schichteigenschaften, insbesondere die Härte der Schicht. Die Biasspannung kann eine Gleichspannung (DC), eine Wechselspannung (AC, MF, RF) oder eine gepulste Spannung (Unipolar, Bipolar) sein.

Im PECVD Verfahren wird das Schichtmaterial gasförmig der Beschichtungskammer zugeführt. An die Substrate wird eine RF oder gepulste Spannung angelegt, die das Gas aufspaltet und zur Abscheidung eines Teils führt. Das Vakuum beim PECVD liegt üblicherweise um Faktor 10 bis 100 höher als beim PVD.

Allen PVD-Verfahren gemeinsam ist, dass das Schichtmaterial sich überwiegend geradlinig von der Quelle ausbreitet bzw. teilweise von den elektrischen Feldlinien abgelenkt wird. Hierdurch entstehen in der Ausbreitung des Schichtmaterials Vorzugsrichtungen, so dass Substratflächen, die entgegen dieser Vorzugsrichtungen orientiert sind, eine besonders hohe Abscheiderate aufweisen.

Substratflächen, die den Vorzugsrichtungen abgewandt sind, werden kaum beschichtet. Um eine homogene Beschichtung der einzelnen Substrate zu erzielen, werden diese in der Beschichtungskammer um mehrere Achsen gesteuert rotiert.

Ausgehend von dem bekannten Antriebsverfahren wird nach der Erfindung vorgeschlagen, dass das Antriebselement die Exzenter rotierend um eine jeweils radial zu der Trägerachse verlaufende Exzenterachse und die Exzenter mindestens einen Mitnehmer um die Trägerachse taumelnd antreiben und der mindestens eine Mitnehmer die Substrathalterungen synchron zu den Exzentern um die jeweilige Substratachse rotierend antreibt. Ein solches Verfahren wird insbesondere mit einem erfindungsgemäßen Substratträger ausgeführt und zeichnet sich gleichermaßen durch dessen vorstehend genannte Vorteile aus.

### Ausführungsbeispiele

Die Erfindung wird nachfolgend anhand von Ausführungsbeispielen erläutert. Es zeigen
- Fig. 1: schematisch eine erfindungsgemäße Beschichtungskammer,
- Fig. 2: eine perspektivische Ansicht eines Substratträgers,
- Fig. 3+4: den Substratträger im Längs- und Querschnitt und
- Fig. 5+6: Details des Substratträgers.

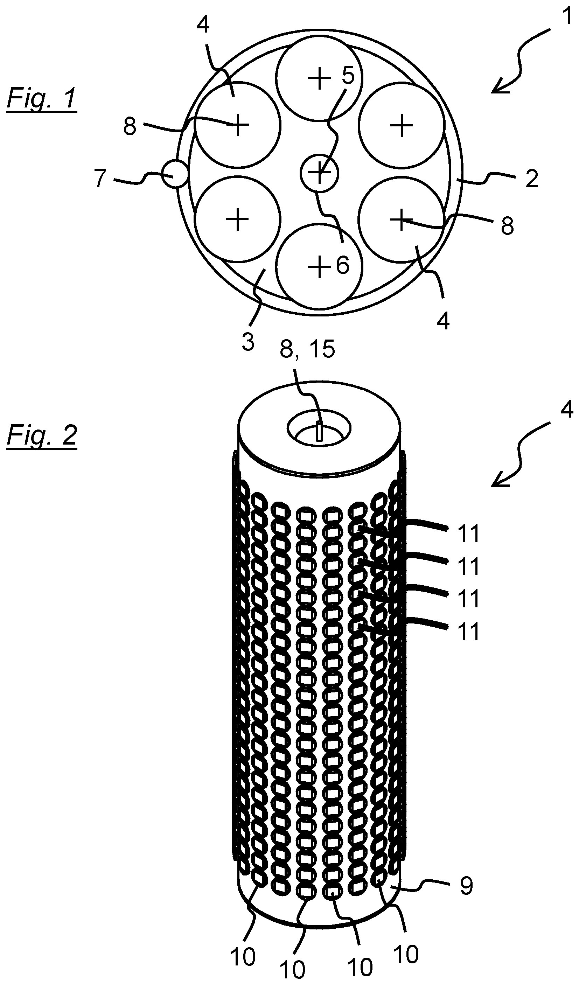

Die in Figur 1 schematisch gezeigte erfindungsgemäße Beschichtungskammer 1 weist über einem Boden 2 einen Tisch 3 mit sechs Substratträgern 4 und in einer vertikal verlaufenden Tischachse 5 einen Gasphasenabscheider 6 auf. Mittels eines Antriebs 7 sind der Tisch 3 um die Tischachse 5 und die Substratträger 4 um ihre jeweils zu der Tischachse 5 parallel verlaufenden Trägerachsen 8 rotierbar.

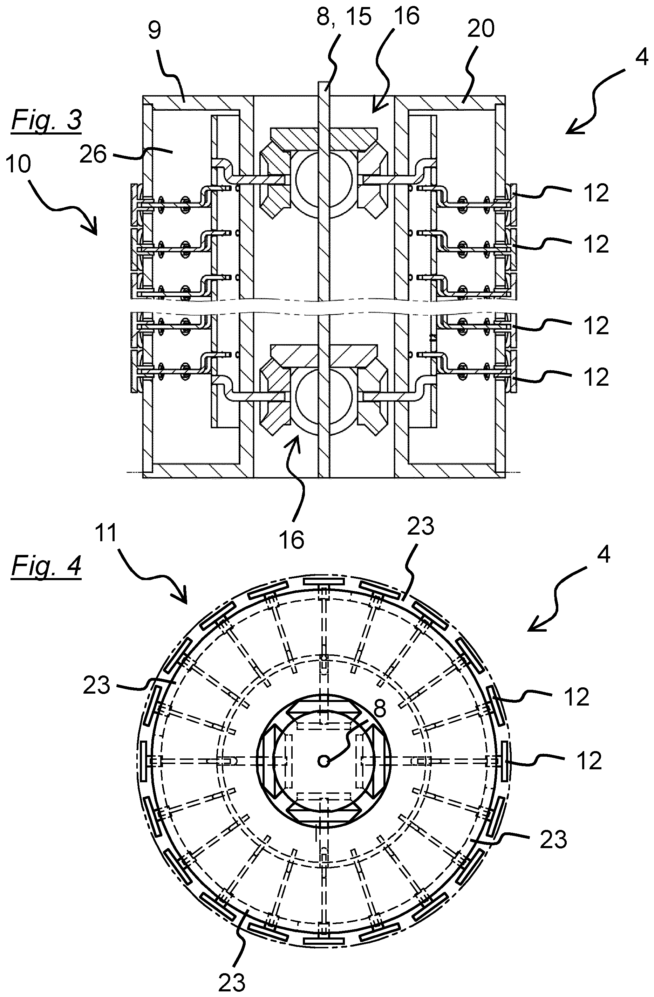

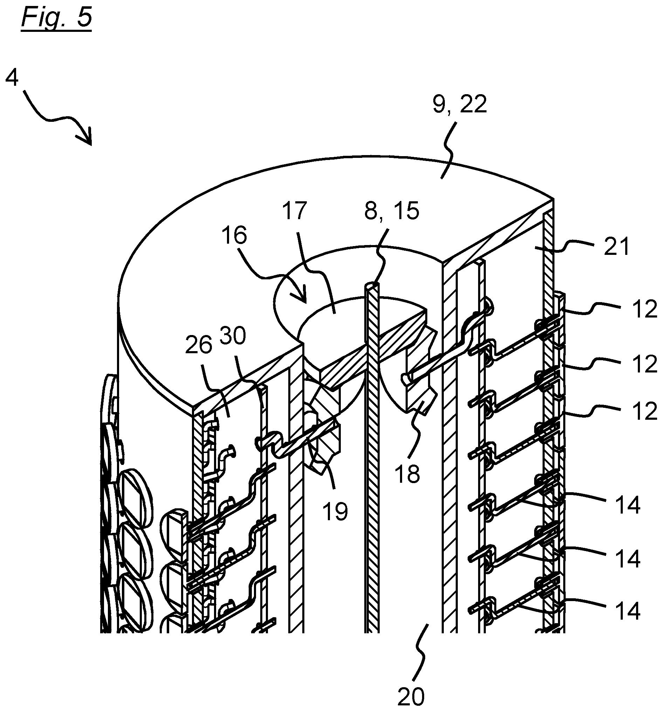

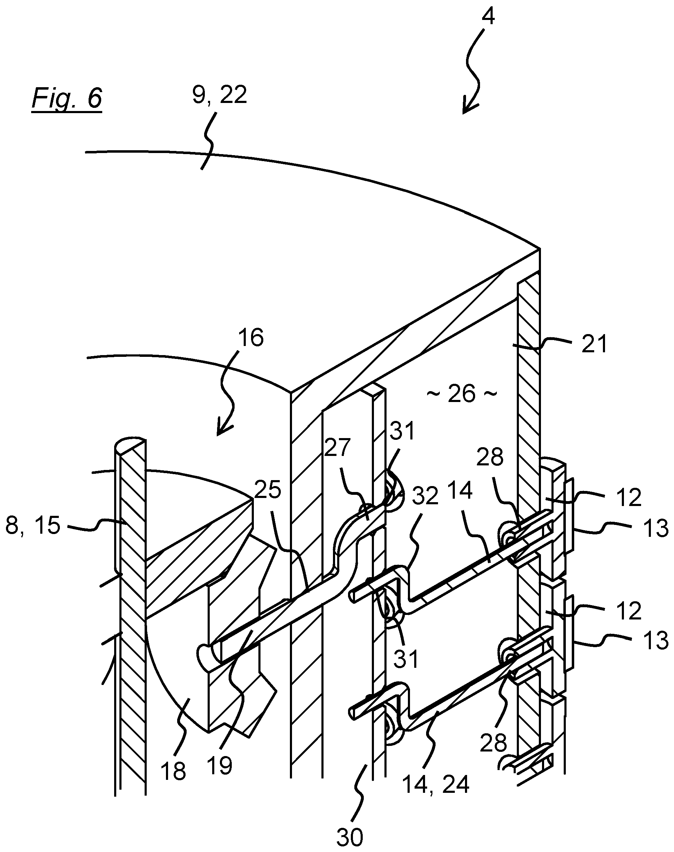

Der beispielhaft einzeln in Figur 2 perspektivisch, in den Figuren 3 und 4 im Schnitt und in den Figuren 5 und 6 im Detail dargestellte Substratträger 4 aus der Beschichtungskammer 1 weist einen um seine Trägerachse 8 angeordneten kreiszylindrischen Mantel 9 auf. In zwanzig parallel zu der Trägerachse 8 verlaufenen Reihen 10 und 24 übereinander angeordneten Kreisen 11 sind außen auf dem Mantel 9 480 Substrathalterungen 12 angebracht.

Die Substrathalterungen 12 sind zum Haltern eines spezifischen Substrats 13 eingerichtet und um eine jeweils radial aus dem Mantel 9 weisende Substratachse 14 rotierbar in dem Mantel 9 gelagert.

In der Trägerachse 8 ist eine um die Trägerachse 8 gegen den Mantel 9 rotierbare Achse als Antriebselement 15 angeordnet. An dem Antriebselement 15 sind oben und unten in dem Substratträger 4 zwei Winkelgetriebe 16 mit je einem horizontal liegenden Kegelrad 17 als Tischrad und darunter je vier mit diesen kämmenden, stehenden Kegelrädern 18 als Ritzel angeordnet, die jeweils mit einem Exzenter 19 fest verbunden sind.

Der Mantel 9 besteht aus einem Innenrohr 20 und einem Außenrohr 21. Das Innenrohr 20 weist oben und unten je einen kreisringförmig radial nach außen verlaufenden Deckel 22 auf, zwischen die das Außenrohr 21 eingesetzt ist. Das Außenrohr 21 ist parallel zu der Trägerachse 8 in vier Segmente 23 geteilt.

Die Exzenter 19 sind um eine jeweils radial zu der Trägerachse 8 verlaufende Exzenterachse 24 rotierbar in Lagerstellen 25 des Innenrohrs 20 gelagert und weisen ein in den Hohlraum 26 zwischen Außenrohr 21 und Innenrohr 20 weisendes gekröpftes Ende 27 auf. Die Substratachsen 14 sind in Lagerstellen 28 des Außenrohrs 21 gelagert und weisen jeweils gleichfalls ein in den Hohlraum 26 hinein weisendes gekröpftes Ende auf. Von den Lagerstellen 25, 28 abgesehen ist der Hohlraum 26 geschlossen, allerdings - aufgrund der Vakuumtechnik - nicht luftdicht.

In dem Hohlraum 26 ist ein rohrförmiger Mitnehmer 30 angeordnet mit Bohrungen 31, in denen die gekröpften Enden 27 der Exzenter 19 und der Substratachsen 14 rotierbar gelagert sind. Die Exzenter 19 tragen in den Bohrungen 31 den Mitnehmer 30.

Im Betrieb der Beschichtungskammer 1 rotiert der Antrieb 7 den Tisch 3 über dem Boden 2 und die Substratträger 4 auf dem Tisch 3. Die Winkelgetriebe 16 wandeln die Rotation der auf dem Tisch 3 feststehenden Antriebselemente 15 um die Trägerachse 8 relativ zum Mantel 9 in eine Rotation der Exzenter 19 um die jeweilige Exzenterachse 24.

Die Rotation der gekröpften Enden 27 der Exzenter 19 um die Exzenterachsen 24 versetzt den Mitnehmer 30 in eine parallel zu der Trägerachse 8 und in Umfangsrichtung taumelnde Bewegung, die über die gekröpften Enden der Substratachsen 14 als Rotation um dieselben auf die Substrathalter übertragen wird.

An den Enden der Substratachsen 14 ist jeweils als Blockadesicherung 32 eine Sollbruchstelle angebracht. Bei einer Blockade der Rotation einer Substrathalterung 12 in dem Außenrohr 21 bricht die jeweilige Substratachse 14 in der Sollbruchstelle, ohne die Beschichtung der übrigen Substrate 13 zu beeinträchtigen. Nach Abschluss der Beschichtung werden die Segmente 23 des Außenrohrs 21 vom Innenrohr 20 abgenommen und gegebenen Falls gebrochene Substratachsen 14 entfernt und ersetzt.

Ein erfindungsgemäßer, aber nicht dargestellter zweiter Substratträger entspricht im Wesentlichem dem ersten Substratträger 4. Abweichend weist der zweite Substratträger unterhalb des ersten Mitnehmers 30 einen gleichfalls rohrförmigen zweiten Mitnehmer auf, der auf dieselbe Weise wie der erste Mitnehmer 30 aber gegenläufig zu diesem angetrieben wird. Der zweite Mitnehmer gleicht im Betrieb die Unwuchten des ersten Mitnehmers 30 aus, so dass der zweite Substratträger gegenüber dem ersten Substratträger 4 ein gleichmäßigeres Antriebsmoment aufweist.

Ein erfindungsgemäßer, aber nicht dargestellter dritter Substratträger entspricht gleichfalls im Wesentlichem dem ersten Substratträger 4. Abweichend ist das Außenrohr des dritten Substratträgers in zwanzig Segmente, also ein Segment je Reihe der Substrathalter unterteilt.

Eine erfindungsgemäße, aber nicht dargestellte zweite Beschichtungskammer entspricht im Wesentlichen der ersten Beschichtungskammer 1. Abweichend weist die zweite Beschichtungskammer außen um den Tisch angeordnete Gasphasenabscheider auf.

### In den Figuren sind

- 1: Beschichtungskammer
- 2: Boden
- 3: Tisch
- 4: Substratträger
- 5: Tischachse
- 6: Gasphasenabscheider
- 7: Antrieb
- 8: Trägerachse
- 9: Mantel
- 10: Reihe
- 11: Kreis
- 12: Substrathalterung
- 13: Substrat
- 14: Substratachse
- 15: Antriebselement
- 16: Winkelgetriebe
- 17: Kegelrad
- 18: Kegelrad
- 19: Exzenter
- 20: Innenrohr
- 21: Außenrohr
- 22: Deckel
- 23: Segment
- 24: Exzenterachse
- 25: Lagerstelle
- 26: Hohlraum
- 27: Ende

- 28: Lagerstelle
- 29: Ende
- 30: Mitnehmer
- 31: Bohrung
- 32: Blockadesicherung

## Patentansprüche

1. Substratträger (4) mit einer vertikal verlaufenden Trägerachse (8) und einem rohrförmig um die Trägerachse (8) angeordneten Mantel (9), Substrathalterungen (12) zum Haltern jeweils eines Substrats (13), die um jeweils eine aus dem Mantel (9) weisende Substratachse (14) rotierbar in dem Mantel (9) gelagert sind, einem Antriebselement (15), das um die Trägerachse (8) relativ zu den Substrathalterungen (12) rotierbar ist, ***gekennzeichnet durch*** Exzenter (19), die das Antriebselement (15) um eine jeweils radial zu der Trägerachse (8) verlaufende Exzenterachse (24) rotierend antreibt und mindestens einen Mitnehmer (30), den die Exzenter (19) um die Trägerachse (8) taumelnd antreiben, und der die Substrathalterungen (12) synchron zu den Exzentern (19) um die jeweilige Substratachse (14) rotierend antreibt.

2. Substratträger (4) nach dem vorgenannten Anspruch ***dadurch gekennzeichnet, dass*** die Exzenter (19) in dem Mantel (9) rotierbar gelagert sind.

3. Substratträger (4) nach einem der vorgenannten Ansprüche, ***gekennzeichnet durch*** jeweils miteinander kämmende Kegelräder (17, 18) an dem Antriebselement (15) und den Exzentern (19), die eine Rotation des Antriebselements (15) in eine Rotation um eine jeweils zu der Trägerachse (8) radiale Exzenterachse (24) der Exzenter (19) wandeln.

4. Substratträger (4) nach einem der vorgenannten Ansprüche, ***dadurch gekennzeichnet, dass*** der mindestens eine Mitnehmer (30) in einem Hohlraum (26) des Mantels angeordnet ist.

5. Substratträger (4) nach den vorgenannten Ansprüchen, ***dadurch gekennzeichnet, dass*** der Hohlraum (26) abgesehen von Lagerstellen (25, 28) der Exzenter (19) und der Substrathalterungen (12) geschlossen ist.

6. Substratträger (4) nach einem der vorgenannten Ansprüche, ***dadurch gekennzeichnet, dass*** der mindestens eine Mitnehmer (30) Bohrungen (31) aufweist, in die die Exzenter (19) und die Substrathalterungen (12) eingreifen.

7. Substratträger (4) nach einem der vorgenannten Ansprüche, ***dadurch gekennzeichnet, dass*** der mindestens eine Mitnehmer (30) eine kreiszylindrische Trommel ist.

8. Substratträger (4) nach einem der vorgenannten Ansprüche, ***dadurch gekennzeichnet, dass*** die Exzenter (19) den mindestens einen Mitnehmer (30) tragen.

9. Substratträger (4) nach einem der vorgenannten Ansprüche, ***dadurch gekennzeichnet, dass*** die Substratachsen (14) im Wesentlichen radial zu der Trägerachse (8) verlaufen.

10. Substratträger (4) nach einem der vorgenannten Ansprüche, ***gekennzeichnet durch*** eine Blockadesicherung (32).

11. Beschichtungskammer (1) mit mindestens einem Tisch (3) parallel über einem Boden (2) der Beschichtungskammer (1), mindestens einer Substratträger (4) nach einem der vorgenannten Ansprüche auf dem mindestens einen Tisch (3) und einem Antrieb (7), mittels dessen der mindestens eine Tisch (3) um eine vertikal verlaufende Tischachse (5) und der mindestens eine Substratträger (4) um die Trägerachse (8) rotierbar ist.

12. Beschichtungskammer (1) nach dem vorgenannten Anspruch,
***gekennzeichnet durch*** einen Gasphasenabscheider (6).

13. Antriebsverfahren für eine Substrathalterung (12) zum Haltern eines Substrats (13) um eine aus einem Mantel (9) weisende Substratachse (14), der um eine vertikal verlaufende Trägerachse (8) eines Substratträgers (4) angeordnet ist, mittels eines um die Trägerachse (8) relativ zu der Substrathalterung (12) rotierenden Antriebselements (15), ***dadurch gekennzeichnet, dass*** das Antriebselement (15) die Exzenter (19) rotierend um eine jeweils radial zu der Trägerachse (8) verlaufende Exzenterachse (24) und die Exzenter (19) mindestens einen Mitnehmer (30) um die Trägerachse (8) taumelnd antreiben und der mindestens eine Mitnehmer (30) die Substrathalterungen (12) synchron zu den Exzentern (19) um die jeweilige Substratachse (14) rotierend antreibt.
